# EUROPEAN PATENT APPLICATION

(11) **EP 2 040 318 A2**
(43) Date of publication of application: **25.03.2009**
(21) Application number: 08016445.2
(22) Date of filing: 18.09.2008
(51) Int. Cl.: H01L 51/56, H01L 51/52

(54) **Patterning method and display device**

(30) Priority: 19.09.2007 JP 2007242918; 14.05.2008 JP 2008127158
(71) Applicant: Fujifilm Corporation, Tokyo 106-0031 (JP)
(72) Inventor: Nishita, Nobuhiro, Ashigarakami-gun Kanagawa 258-8577 (JP)
(74) Representative: HOFFMANN EITLE

(57) **Abstract**

A wet-etching is conducted with a weak acid or weak base etchant to pattern a display device substrate that has a gas-barrier layer comprising at least one organic region and at least one inorganic region. The wet-etching attains high-precision patterning not having any negative influence on the quality of the processed display device.

## Description

### TECHNICAL FIELD

The present invention relates to a method for patterning a display device substrate, a display device substrate patterned according to the patterning method, a method for producing a display device that comprises patterning a substrate according to the patterning method, and a display device produced according to the display device production method.

### BACKGROUND ART

Heretofore, patterning is employed in producing an organic EL device (organic electroluminescent device). For example, JP-A 2004-146136 describes a method for patterning a thin film layer of anode by etching a thin metal film layer with a mixed acid of phosphoric acid, nitric acid and acetic acid and further etching it with oxalic acid. However, patterning of an organic EL device that comprises an organic/inorganic laminate gas-barrier film as the substrate thereof requires various investigations since the gas-barrier film has a complicated layer constitution comprising an organic region and an inorganic region.

On the other hand, JP-A 2007-76036 describes a technique of etching a polyamide film that comprises a lamination of a transparent thin film layer of an inorganic oxide formed by vapor deposition and a water-soluble polymer-containing gas-barrier film layer. However, the etching is attained by plasma treatment, and this has no correlation at all with organic EL devices.

### SUMMARY OF THE INVENTION

As mentioned in the above, nothing has heretofore been investigated about patterning of a display device substrate that comprises an organic/inorganic laminate gas-barrier film. In particular, when a strong acid or a strong base that has heretofore been widely used as an etchant is applied to a gas-barrier film, then it causes damage to the gas-barrier film and the quality of the finally obtained display devices is thereby worsened. The present invention is to solve the problems and its object is to provide a patterning method capable of attaining high-precision patterning not having any negative influence on the quality of the processed display device.

Given that situation, the present inventors have assiduously studied and, as a result, have found that the above problems can be solved by the following means.
(1) A method for patterning a display device substrate that has a gas-barrier layer comprising at least one organic region and at least one inorganic region, which comprises patterning the display device substrate by wet-etching with a weak acid or weak base etchant.
(2) The patterning method according to (1), wherein the weak acid or the weak base of the etchant has a pKa falling within a range of from 0.5 to 10.
(3) The patterning method according to (1) or (2), wherein the etchant is selected from an oxalic acid solution, an acetic acid solution, a carbonic acid solution and a phosphoric acid solution and a mixture of at least two of them.
(4) The patterning method according to any one of (1) to (3), wherein the etchant is an aqueous solution of oxalic acid.
(5) The patterning method according to any one of (1) to (4), wherein the display device substrate has a transparent electrode and the transparent electrode is subject to the patterning.
(6) The patterning method according to any one of (1) to (5), wherein the display device substrate has a thin film layer of anode and the thin film layer is subject to the patterning.
(7) The patterning method according to any one of (1) to (6), wherein the display device substrate has an ITO thin film and the ITO thin film is subject to the patterning.
(8) The patterning method according to any one of (1) to (7), wherein the gas-barrier layer is a laminate comprising at least one organic layer and at least one inorganic layer.
(9) The patterning method according to (8), wherein the at least one organic layer and the at least one inorganic layer are laminated alternately.
(10) A display device substrate patterned by the patterning method of any one of (1) to (9).
(11) A method for producing a display device, which comprises patterning a substrate by the patterning method of any one of (1) to (9).
(12) A display device produced by the patterning method of (11).

The invention has made it possible to pattern a display device substrate not having any influence on the display quality.

### DETAILED DESCRIPTION OF THE INVENTION

The contents of the invention are described in detail hereinunder. In this description, the numerical range expressed by the wording "a number to another number" means the range that falls between the former number indicating the lowermost limit of the range and the latter number indicating the uppermost limit thereof.

### «Patterning method»

The method for patterning a display device substrate of the invention is characterized in that a display device substrate having a gas-barrier layer that comprises at least one organic region and at least one inorganic region is wet-etched and that a weak acid or weak base etchant is used for the etching.

### (Etchant)

The etchant for use in the patterning method of the invention is a weak acid or a weak base, preferably having a pKa falling within a range of from 0.5 to 10, more preferably from 1.0 to 9.5. The etchant can etch a display device substrate not causing damage to the substrate, and can pattern the substrate with accuracy. The etchant in the invention is preferably selected from oxalic acid, acetic acid, carbonic acid and phosphoric acid, and a mixture at least two of them. More preferred are oxalic acid and acetic acid.

Regarding the other detailed conditions of wet etching and the other processing steps than patterning, herein employable are any known techniques, and for example, the methods described in JP-A 3-250583 and 2006-59831, and Junji Kido's "Organic EL Materials and Displays" (by CMC, 2001).

### «Display device substrate»

### (Gas-Barrier Layer)

The display device substrate of the invention has a gas-barrier layer comprising at least one organic region and at least one inorganic region. The gas-barrier layer has a function of blocking oxygen and moisture in air, and may have a constitution of at least one organic layer and at least one inorganic layer laminated alternately, or may be a graded material layer where the regions continuously change in the direction of the thickness of the film. Not specifically defined, the number of the layers constituting the gas-barrier layer is typically preferably from 2 layers to 30 layers, more preferably from 3 layers to 20 layers. In general, the gas-barrier layer is provided on a substrate film; and it may be provided on only one surface of a substrate film or on both surfaces thereof.

Examples of the graded materials include the materials described in a report by Kim et al., in Journal of Vacuum Science and Technology A, Vol. 23, pp. 971-977 (2005 American Vacuum Society); and a continuous laminate of an organic layer and an organic layer with no interface therebetween as in USP-A 2004-46497. As one example, a gas-barrier layer comprising a lamination of an organic layer and an inorganic layer is described below, but the same shall apply to the other case of a graded material layer.

### (Substrate film)

The substrate film of the invention is generally a plastic film. The plastic film to be used is not particularly limited with respect to the material quality and thickness, etc. so far as it is a film capable of keeping a stacklaminate of an organic layer, an inorganic layer and the like and can be properly chosen depending upon the use purpose or the like. Specific examples of the plastic film include thermoplastic resins such as polyester resins, methacrylic resins, methacrylic acid-maleic acid copolymers, polystyrene resins, transparent fluorocarbon resins, polyimides, fluorinated polyimide resins, polyamide resins, polyamide-imide resins, polyetherimide resins, cellulose acylate resins, polyurethane resins, polyetheretherketone resins, polycarbonate resins, alicyclic polyolefin resins, polyarylate resins, polyethersulfone resins, polysulfone resins, cycloolefin copolymers, fluorene ring-modified polycarbonate resins, alicyclic modified polycarbonate resins, fluorene ring-modified polyester resins and acryloylated compounds.

In the case where the display device substrate of the invention is used as a substrate of a device such as organic EL devices as described later, it is preferable that the plastic film is composed of a raw material with heat resistance. Specifically, it is preferable that the plastic film is composed of a transparent raw material with high heat resistance having a glass transition temperature (Tg) of 100 °C or higher and/or a linear heat expansion coefficient of not more than 40 ppm/°C. The Tg and linear heat expansion coefficient can be adjusted by an additive or the like. Examples of such a thermoplastic resin include polyethylene naphthalate (PEN: 120 °C), polycarbonate (PC: 140 °C), alicyclic polyolefins (for example, ZEONOR 1600, manufactured by Zeon Corporation: 160 °C), polyarylate (PAr: 210 °C), polyethersulfone (PES: 220 °C), polysulfone (PSF: 190 °C), cycloolefin copolymers (COC: a compound described in Example 1 of JP-A-2001-150584: 162 °C), polyimides (for example, NEOPULIM, manufactured by Mitsubishi Gas Chemical Company, Inc.: 260 °C), fluorene ring-modified polycarbonate (BCF-PC, a compound described in JP-A-2000-227603: 225 °C), alicyclic modified polycarbonate (IP-PC, a compound described in JP-A-2000-227603: 205 °C) and acryloyl compound (a compound described in JP-A-2002-80616: 300 °C or higher) (the numerical figure in each of the parentheses indicates Tg). In particular, in the case where the transparency is required, it is preferable to use an alicyclic polyolefin or the like.

In the case where the display device substrate of the invention is used in combination with a polarizing plate, it is preferable that the barrier laminate of the display device substrate is faced at the inside of a cell and is disposed in the innermost (adjacent to the device). At that time, since the display device substrate is disposed in the inside of the cell relative to the polarizing plate, a retardation value of the display device substrate is important. As to a use form of the display device substrate in such an embodiment, it is preferable that a barrier film using a base material film having a retardation value of not more than 10 nm and a circular polarizing plate ((quarter-wave plate) + (half-wave plate) + (linear polarizing plate)) are stackedlaminated and used, or that a linear polarizing plate is combined with a display device substrate using a base material film having a retardation value of from 100 nm to 180 nm, which can be used as a quarter-wave plate, and used.

Examples of the base material film having a retardation of not more than 10 nm include cellulose triacetate (FUJITAC, manufactured by Fujifilm Corporation), polycarbonates (PURE-ACE, manufactured by Teijin Chemicals Ltd.; and ELMECH, manufactured by Kaneka Corporation), cycloolefin polymers (ARTON, manufactured by JSR Corporation; and ZEONOR, manufactured by Zeon Corporation), cycloolefin copolymers (APEL (pellet), manufactured by Mitsui Chemicals, Inc.; and TOPAS (pellet), manufactured by Polyplastics Co., Ltd.), polyarylates (U100 (pellet), manufactured by Unitika Ltd.) and transparent polyimides (NEOPULIM, manufactured by Mitsubishi Gas Chemical Company).

Also, films obtained by properly stretching the foregoing film to adjust it so as to have a desired retardation value can be used as the quarter-wave plate.

In view of the matter that the display device substrate of the invention is utilized as a device such as organic EL devices, the plastic film must be transparent, namely its light transmittance is usually 80% or more, preferably 85% or more, and more preferably 90% or more. The light transmittance can be measured by a method described in JIS-K7105, namely by measuring a total light transmittance and an amount of scattered light using an integrating sphere type light transmittance analyzer and subtracting the diffuse transmittance from the total light transmittance.

Even in the case where the display device substrate of the invention is used for display use, for example, when it is not disposed on the side of an observer, the transparency is not always required. Accordingly, in such case, an opaque material can also be used as the plastic film. Examples of the opaque material include known liquid crystal polymers such as polyimides and polyacrylonitrile.

The thickness of the plastic film to be used for the display device substrate of the invention is properly chosen depending upon the use and therefore, is not particularly limited. It is typically from 1 to 800 µm, and preferably from 10 to 200 µm. These plastic films may have a functional layer such as a transparent conductive layer and a primer layer. The functional layer is described in detail in paragraphs 0036 to 0038 of JP-A-2006-289627. Examples of functional layers other than these layers include a matting agent layer, a passivation layer, a smoothening layer, an adhesion improving layer, a light shielding layer, an antireflection layer, a hard coat layer, a stress relaxing layer, an antifogging layer, an antifouling layer, a layer to be printed and an easily adhesive layer.

### (Inorganic Layer)

The inorganic layer is, in general, a layer of a thin film formed of a metal compound. For forming the inorganic layer, employable is any method capable of producing the intended thin film. For it, for example, suitable is a coating method, sputtering method, a vacuum evaporation method, an ion-plating method or a plasma CVD method. Concretely, the methods described in Japanese Patent No. 3400324, JP-A 2002-322561, 2002-361774 are employable herein.

Not specifically defined, the component to be in the inorganic layer may be any one that satisfies the above-mentioned performance, for which, for example, employable are oxides, nitrides, carbides, oxinitrides, oxycarbides, nitrocarbides, oxynitrocarbaides containing at least one metal selected from Si, Al, In, Sn, Zn, Ti, Cu, Ce and Ta. Of those preferred are oxides, nitrides or oxinitrides of a metal selected from Si, Al, In, Sn, Zn and Ti; and more preferred are metal oxides, nitrides or oxinitrides with Si or Al. These may contain any other element as a subsidiary component.

Not specifically defined, the thickness of the inorganic layer is preferably within a range of from 5 nm to 500 nm, more preferably from 10 nm to 200 nm. Two or more inorganic layers may be laminated, and in such a case, the constitutive layers may have the same or different compositions. As described above, the composition of the inorganic layer may be continuously changed in a thickness direction of the film with no clear interface between the inorganic layer and an organic layer as in USP-A 2004-46497.

### (Organic layer)

The organic layer is generally a polymer layer. Concretely, this is a layer of polyester, acrylic resin, methacrylic resin, methacrylic acid/maleic acid copolymer, polystyrene, transparent fluororesin, polyimide, fluoropolyimide, polyamide, polyamidimide, polyetherimide, cellulose acylate, polyurethane, polyether-ether ketone, polycarbonate, alicyclic polyolefin, polyarylate, polyether sulfone, polysulfone, fluorene ring-modified polycarbonate, alicyclic-modified polycarbonate, fluorene ring-modified polyester, acryloyl compound or the like thermoplastic resin, or polysiloxane or any other organic silicon compound. The organic layer may be formed of a single material or a mixture of different materials. Two or more organic layers may be laminated. In this case, the constitutive layers may have the same composition or may have different compositions. As so mentioned in the above, the organic layer may be such that the boundary of the layer to the adjacent inorganic layer is indefinite and the composition thereof continuously changes in the film thickness direction, as in USP-A 2004-46497.

Preferably, the organic layer is smooth and has a high film hardness. Regarding the smoothness of the organic layer, the mean roughness of the layer of 10 µm square (Ra value) is preferably at most 10 nm, more preferably at most 2 nm. The pencil hardness of the layer is preferably at least HB, more preferably at least H.

The thickness of the organic layer is not specifically defined. When too thin, however, the layer could hardly have a uniform thickness; and when too thick, the layer may be cracked by external force and its barrier properties may be thereby worsened. From these viewpoints, the thickness of the organic layer is preferably from 10 nm to 2 µm, more preferably from 100 nm to 1 µm.

For forming the organic layer, for example, employable is an ordinary solution coating method or vacuum film formation method. The solution coating method includes, for example, a dipping method, an air knife coating method, a curtain coating method, a roller coating method, a wire bar coating method, a gravure coating method, a slide coating method, and an extrusion coating method using a hopper described in USP 2681294. The vacuum film formation method is not specifically defined. Preferably, the method is for film formation through vapor deposition or plasma CVD. In the invention, a polymer solution may be used in the solution coating method for forming the organic layer; or a hybrid coating method with an inorganic substance-containing material, as in JP-A 2000-323273 and 2004-25732, may also be employed for the organic layer formation. A film of a polymer precursor (e. g. , monomer) may be first formed, and this may be polymerized to give a polymer layer. Preferred examples of the monomer for use in the invention are acrylates and methacrylates. Preferred examples of acrylates and methacrylates are, for example, the compounds described in USP 6083628 and 6214422. Some of these are shown below.

In the invention, the organic layer preferably comprises a polymer produced by polymerization of a radical-polymerizable compound and/or a cationic polymerizable compound having an ether group as a functional group.

### (Polymerizable Compound)

The polymerizable compound for use in the invention is a compound having an ethylenic unsaturated bond at the terminal or in the side chain thereof, and/or a compound having epoxy or oxetane at the terminal or in the side chain thereof. Of those, preferred is a compound having an ethylenic unsaturated bond at the terminal or in the side chain thereof. Examples of the compound having an ethylenic unsaturated bond at the terminal or in the side chain thereof include (meth)acrylate compounds (acrylate and methacrylate are expressed as (meth)acrylate as combined), acrylamide compounds, styrene compound, maleic anhydride, etc.

As (meth)acrylate compounds, preferred are (meth)acrylates, urethane-(meth)acrylates, polyester-(meth)acrylates, epoxy(meth)acrylates, etc.

As styrene compounds, preferred are styrene, α-methylstyrene, 4-methylstyrene, divinylbenzene, 4-hydroxystyrene, 4-carboxystyrene, etc.

Specific examples of (meth)acrylate compounds are mentioned below, to which, however, the invention should not be limited.

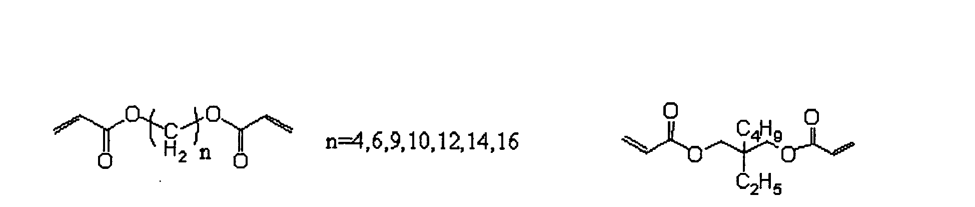

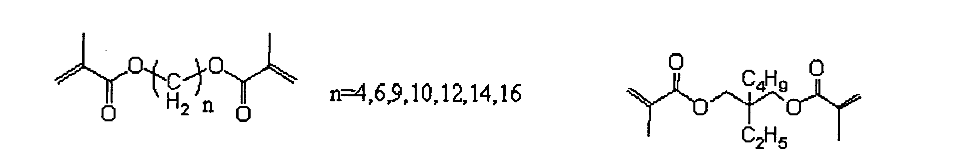

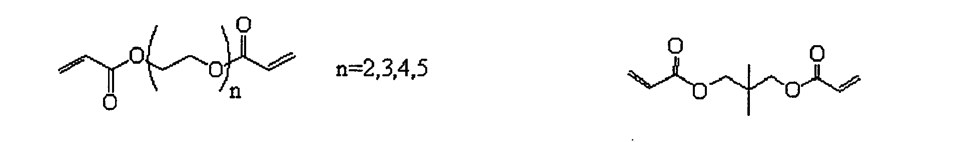

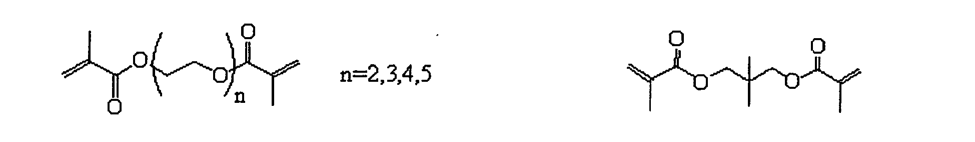

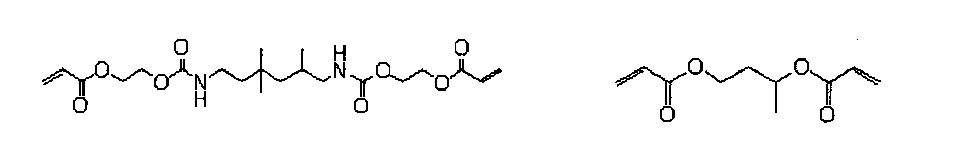

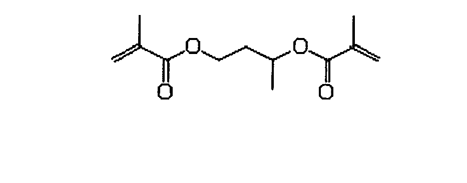

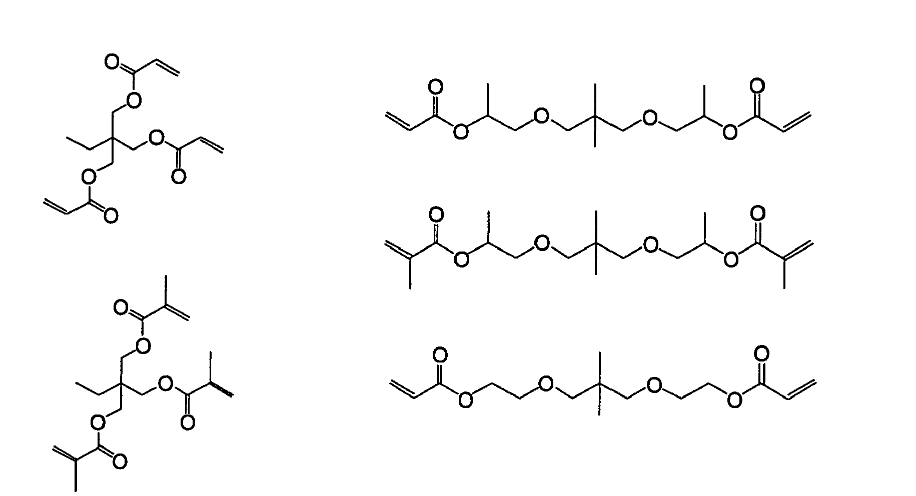

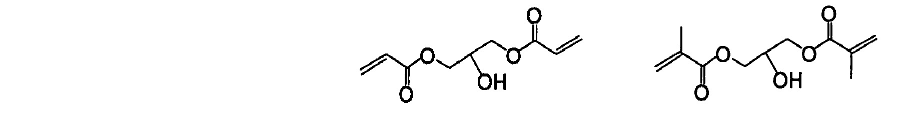

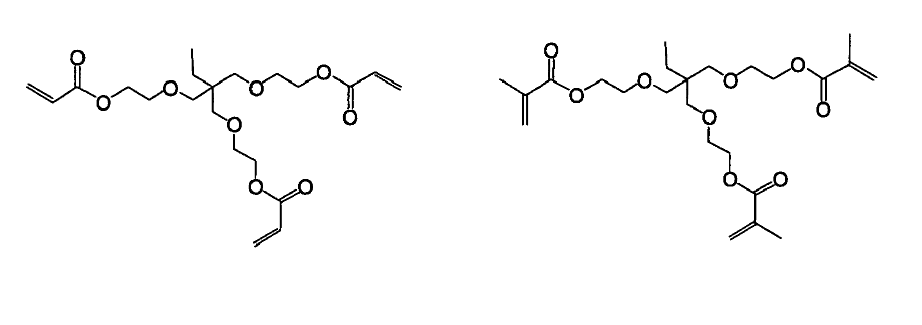

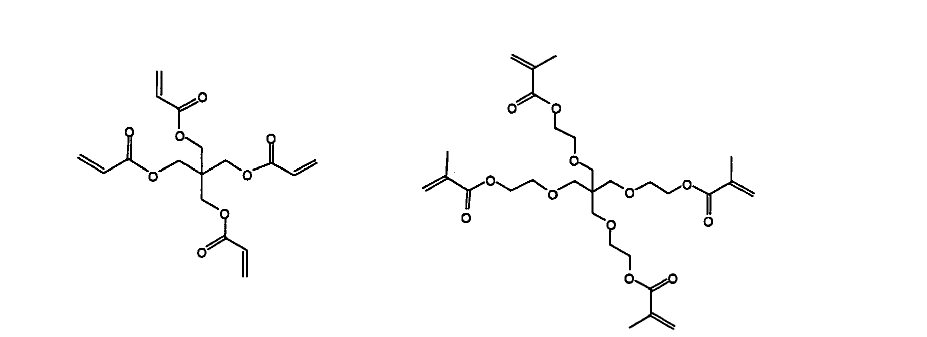

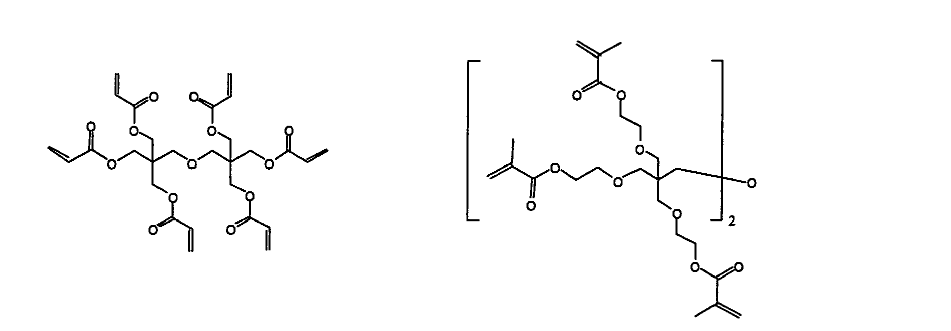

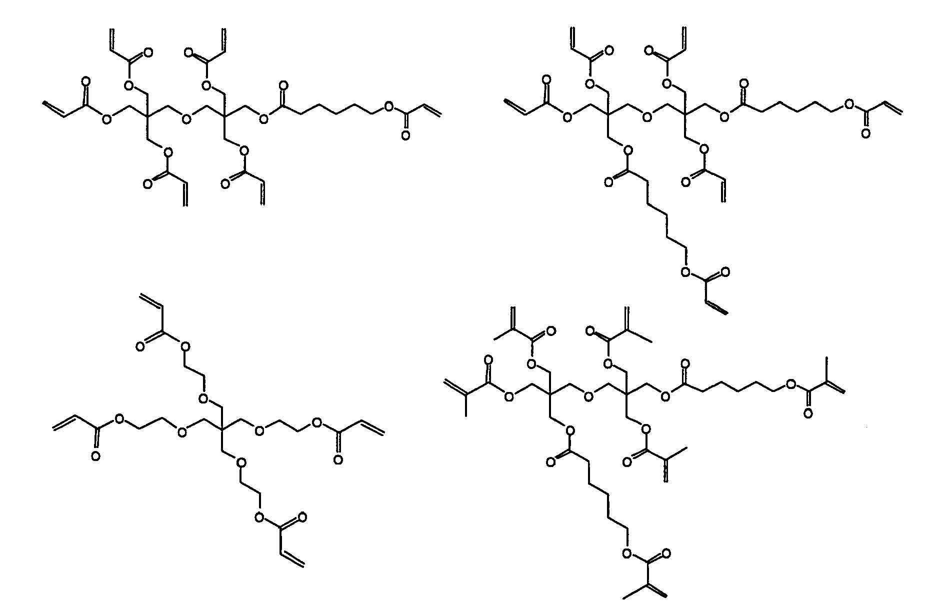

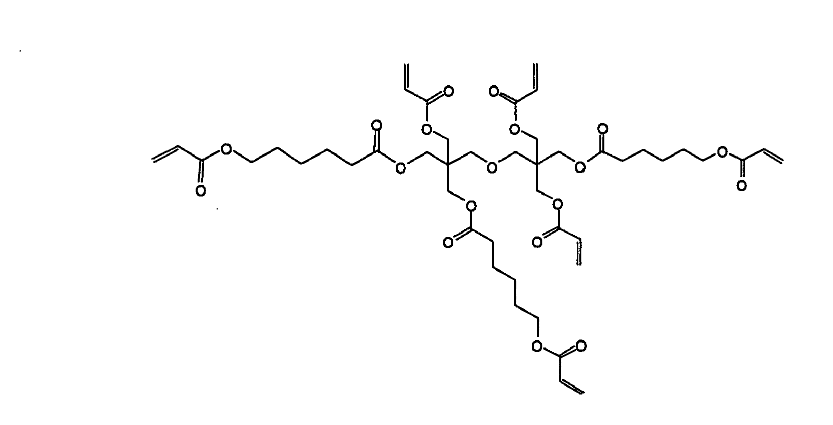

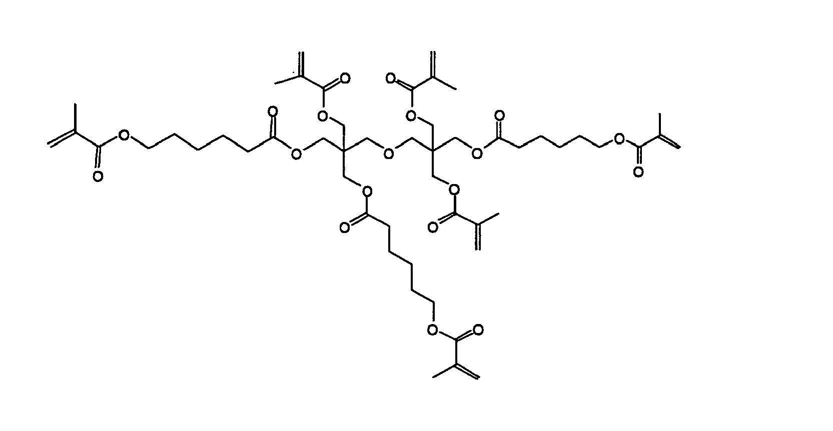

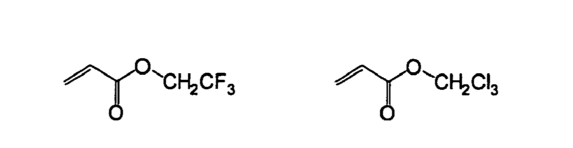

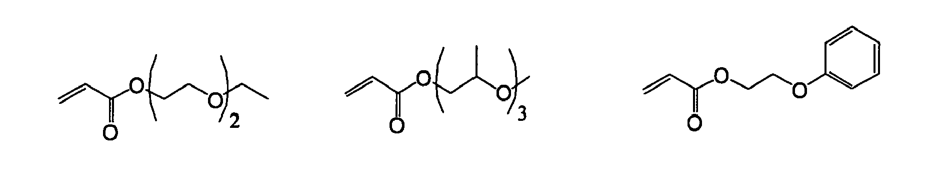

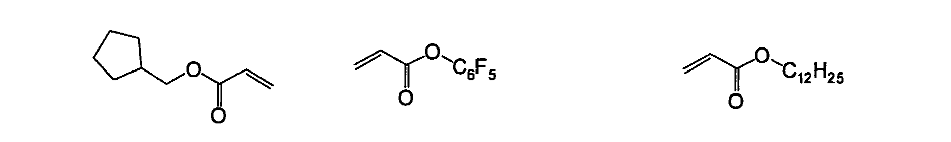

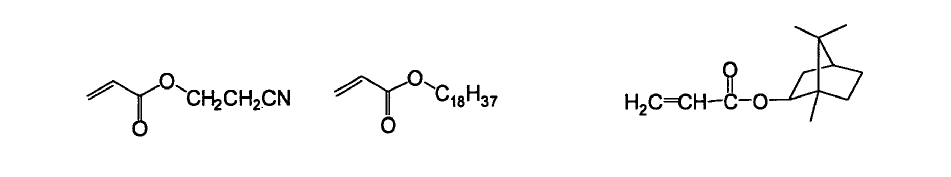

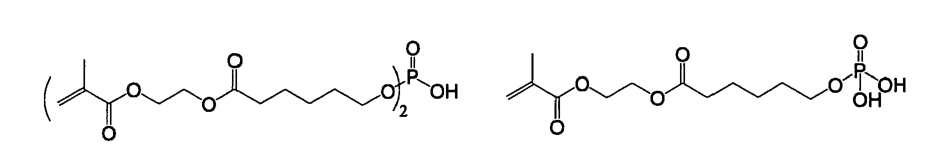

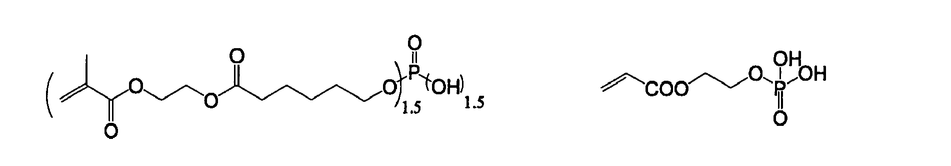

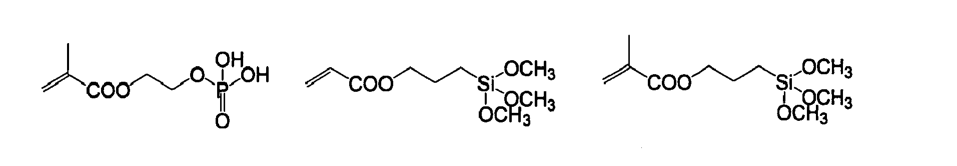

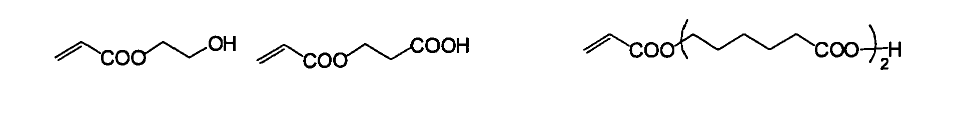

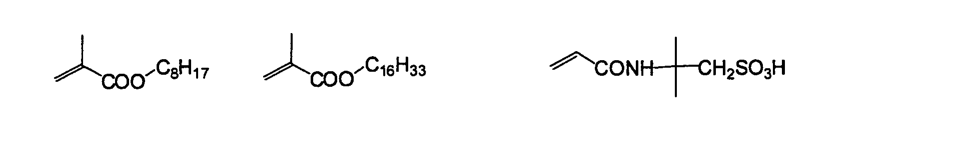

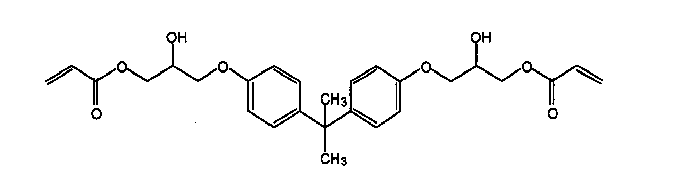

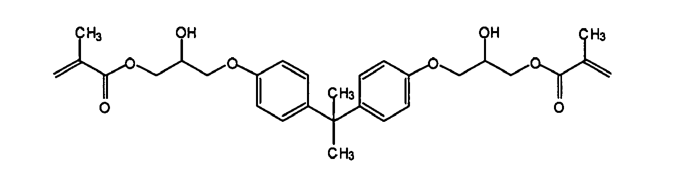

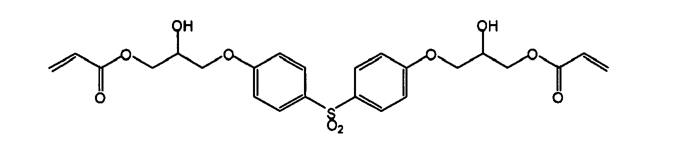

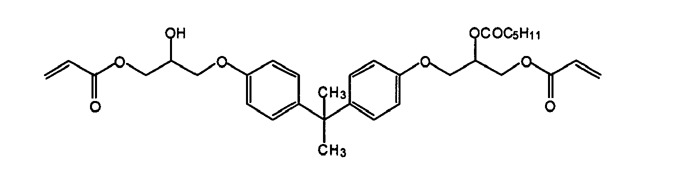

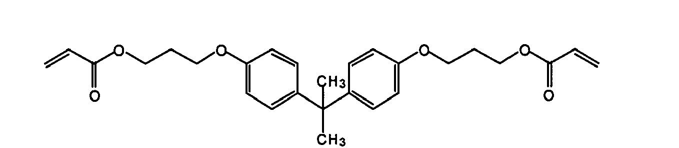

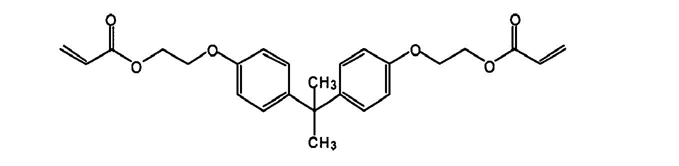

Though the monomer polymerization method is not particularly limited, heat polymerization, photo (ultraviolet ray or visible light) polymerization, electron beam polymerization, plasma polymerization or a combination thereof is preferably employed. In the case where heat polymerization is carried out, the substrate film used as a substrate must be heat resistant to an appropriate extent. The glass transition temperature (Tg) of the substrate film is required to be higher than the heating temperature.

In the case where photopolymerization is carried out, a photopolymerization initiator is used in combination. Examples of the photopolymerization initiator include IRGACURE series (for example, IRGACURE 651, IRGACURE 754, IRGACURE 184, IRGACURE 2959, IRGACURE 907, IRGACURE 369, IRGACURE 379 AND IRGACURE 819), DAROCURE series (for example, DAROCURE TPO and DAROCURE 1173) and QAUNTACURE PDO, all of which are marketed by Ciba Specialty Chemicals; and EZACURE series (for example, EZACURE TZM and EZACURE TZT) which are marketed by Sartomer Company.

The light to be irradiated is usually an ultraviolet ray to be emitted from a high pressure mercury vapor lamp or a low pressure mercury vapor lamp. The irradiation energy is preferably 0.5 J/cm² or more, and more preferably 2 J/cm² or more. Since the acrylate or methacrylate is affected by polymerization inhibition due to oxygen in air, it is preferable to reduce the oxygen concentration or oxygen partial pressure at the time of polymerization. In the case of reducing the oxygen concentration at the time of polymerization by a nitrogen purge method, the oxygen concentration is preferably not more than 2%, and more preferably not more than 0.5%. In the case of reducing the oxygen partial pressure at the time of polymerization by a pressure reducing method, the total pressure is preferably not more than 1,000 Pa, and more preferably not more than 100 Pa. Also, it is especially preferable to carry out ultraviolet ray polymerization upon irradiation with energy of 2 J/cm² or more under a reduced pressure condition of not more than 100 Pa.

The polymerization degree of the monomer is preferably 80% or more, more preferably 85% or more, still more preferably 90% or more. The "polymerization degree" used here means the percentage of reacted polymerizable groups out of all polymerizable groups (acryloyl group and methacryloyl group) in the monomer mixture.

### «Display device»

The display device in the invention is meant to include circular polarizer, liquid-crystal display element, touch panel, and organic EL device.

### <Circularly polarizing plate>

The circularly polarizing plate can be prepared by stacking laminating a λ/4 plate and a polarizing plate on the display substrate of the invention. In that case, the both plates are stackedlaminated in such a manner that a slow axis of the λ/4 plate and an absorption axis of the polarizing plate form 45°. As such a polarizing plate, one stretched in a direction of 45° against the machine direction (MD) thereof is preferably used, and those described in, for example, JP-A-2002-865554 can be favorably used.

### <Liquid crystal display device>

The reflection type liquid crystal display device is configured to include a lower substrate, a reflection electrode, a lower alignment film, a liquid crystal layer, an upper alignment film, a transparent electrode, an upper substrate, a λ/4 plate and a polarizing film in order from the lower side. The display substrate of the invention can be used as a transparent electrode substrate and an upper substrate. In the case of giving a color displaying function to the reflection type liquid crystal display device, it is preferable to further provide a color filter layer between the reflection electrode and the lower alignment film or between the upper alignment film and the transparent electrode.

Also, the transmission type liquid crystal display device is configured to include a backlight, a polarizing plate, a λ/4 plate, a lower transparent electrode, a lower alignment film, a liquid crystal layer, an upper alignment film, an upper transparent electrode, an upper substrate, a λ/4 plate and a polarizing plate in order from the lower side. The substrate of the invention can be used as an upper alignment film, an upper transparent electrode. Also, in the case of giving a color displaying function to the transmission type liquid crystal display device, it is preferable to further provide a color filter layer between the lower transparent electrode and the lower alignment film or between the upper alignment film and the upper transparent electrode.

Though the structure of the liquid crystal layer is not particularly limited, it is preferably of, for example, a TN (twisted nematic) type, an STN (super twisted nematic) type, an HAN (hybrid aligned nematic) type, a VA (vertically alignment) type, an ECB (electrically controlled birefringence) type, an OCB (optically compensated bend) type, a CPA (continuous pinwheel alignment) type or an IPS (in-plane switching) type.

### <Touch panel>

As the touch panel, one obtained by applying the gas barrier film of the invention onto a substrate described in, for example, JP-A-5-127822 or JP-A-2002-48913 can be used.

### <Organic EL device>

An "organic EL device" means an organic electroluminescent device. The display substrate of the invention can be used as a substrate of the organic EL device. The organic EL device has a cathode and an anode on a substrate and has an organic compound layer including an organic light-emitting layer between the both electrodes. In view of properties of the light-emitting device, it is preferable that at least one electrode of the anode and the cathode is transparent.

In the invention, an embodiment of the laminate of the organic compound layer is preferably an embodiment in which a hole transport layer, a light-emitting layer and an electron transport layer are laminated in order from the anode side. Furthermore, a charge blocking layer may be provided between the hole transport layer and the light-emitting layer or between the light-emitting layer and the electron transport layer. A hole injection layer may be provided between the anode and the hole transport layer; and an electron injection layer may be provided between the cathode and the electron transport layer. The light-emitting layer may comprise only one layer, or may be divided into a first light-emitting layer, a second light-emitting layer, and a third light-emitting layer, and the like. Each of the layers may be divided into plural secondary layers.

Although the thickness of the substrate of the invention is not specifically limited, it is preferably 30 µm to 700 µm, more preferably 40 µm to 200 µm, still more preferably 50 µm to 150 µm. In any cases, the haze is preferably 3% or less, more preferably 2% or less, still more preferably 1% or less. The total light transmittance is preferably at least 70%, more preferably at least 80%, still more preferably at least 90%.

### (Anode)

In general, the anode may have a function as an electrode capable of supplying a hole into the organic compound layer and is not particularly limited as to its shape, structure and size or the like. The anode can be properly chosen among known electrode materials depending upon the use and purpose of the light-emitting device. As described previously, the anode is usually provided as a transparent anode. The transparent anode is described in detail in New Developments of Transparent Conducting Films, supervised by SAWADA, Yutaka (published by CMC Publishing Co., Ltd., 1999). In the case of using a plastic base material with low heat resistance, a transparent anode obtained through fabrication at a low temperature of not higher than 150 °C using ITO or IZO is preferable.

### (Cathode)

In general, the cathode may have a function as an electrode capable of injecting an electron into the organic compound layer and is not particularly limited as to its shape, structure and size or the like. The cathode can be properly chosen among known electrode materials depending upon the use and purpose of the light-emitting device.

As materials constituting the cathode, for example, metals, alloys, metal oxides, electric conductive materials or mixtures thereof can be exemplified. Specific examples thereof include alkaline earth metals (for example, Mg and Ca) , gold, silver, lead, aluminum, a sodium-potassium alloy, a lithium-aluminum alloy, a magnesium-silver alloy, indium and rare earth metals (for example, ytterbium). Though these materials may be used singly, from the standpoint of making stability and electron injection properties compatible with each other, two or more kinds of these materials can be favorably used in combination.

Of these, the material constituting the cathode is preferably a material composed mainly of aluminum.

The material composed mainly of aluminum refers to aluminum alone or an alloy of aluminum and from 0.01 to 10% by mass of an alkali metal or an alkaline earth metal or a mixture thereof (for example, a lithium-aluminum alloy and a magnesium-aluminum alloy). The cathode material is described in detail in JP-A-2-15595 and JP-A-5-121172. Also, a dielectric layer composed of a fluoride or oxide of an alkali metal or alkaline earth metal or the like may be inserted in a thickness of from 0.1 to 5 nm between the cathode and the organic compound layer. This dielectric layer can be considered as a certain kind of the electron injection layer.

The thickness of the cathode can be properly chosen depending upon the material constituting the cathode and cannot be unequivocally defined. However, the thickness of the cathode is in general from about 10 nm to 5 µm, and preferably from 50 nm to 1 µm.

Also, the cathode may be transparent or opaque. The transparent cathode can be formed by thinly fabricating the cathode material in a thickness of from 1 to 10 nm and further laminating a transparent conductive material such as ITO and IZO thereon.

### (Organic compound layer)

The organic electroluminescent device of the invention has at least one organic compound layer including a light-emitting layer. As described previously, examples of other organic compound layers than the organic light-emitting layer include respective layers such as a hole transport layer, an electron transport layer, a charge blocking layer, a hole injection layer and an electron injection layer.

### ((Organic light-emitting layer))

The organic light-emitting layer is a layer having a function such that at the time of application of an electric field, it receives a hole from the anode, the hole injection layer or the hole transport layer and receives an electron from the cathode, the electron injection layer or the electron transport layer to provide a field of recombination of the hole and the electron, thereby achieving light emission. The light-emitting layer may be constituted of only a light-emitting material or may be configured as a mixed layer of a host material and a light-emitting material. The light-emitting material may be a fluorescent light-emitting material or a phosphorescent light-emitting material; and a dopant may be a single material or a combination of two or more kinds of materials. The host material is preferably a charge transport material. The host material may be a single material or a combination of two or more kinds of materials, and examples thereof include a constitution of a mixture of an electron transporting host material and a hole transporting host material. Furthermore, the light-emitting layer may contain a material which does not have charge transporting properties and does not emit light. Also, the light-emitting layer may be a single layer or may be configured of two or more layers, and the respective layers may emit light in a different luminescent color.

Examples of the fluorescent light-emitting material which can be used in the invention include compounds, for example, benzoxazole derivatives, benzimidazole derivatives, benzothiazole derivatives, styrylbenzene derivatives, polyphenyl derivatives, diphenylbutadiene derivatives, tetraphenylbutadiene derivatives, naphthalimide derivatives, coumarin derivatives, condensed aromatic compounds, perynone derivatives, oxadiazole derivatives, oxazine derivatives, aldazine derivatives, pyralidine derivatives, cyclopentadiene derivatives, bisstyrylanthracene derivatives, quinacridone derivatives, pyrrolopyridine derivatives, thiadiazolopyridine derivatives, cyclopentadiene derivatives, styrylamine derivatives, diketopyrrolopyrrole derivatives, aromatic dimethylidyne derivatives, various metal complexes represented by metal complexes of 8-quinolinol derivatives and pyrromethene derivatives, polymer compounds (for example, polythiophene, polyphenylene and polyphenylenevinylene) and organosilane derivatives.

Examples of the phosphorescent light-emitting material include complexes containing a transition metal atom or a lanthanoid atom.

The transition metal atom is not particularly limited, and preferred examples thereof include ruthenium, rhodium, palladium, tungsten, rhenium, osmium, iridium and platinum, with rhenium, iridium and platinum being more preferable.

Examples of the lanthanoid atom include lanthanum, cerium, praseodymium, neodymium, samarium, europium, gadolinium, terbium, dysprosium, holmium, erbium, thulium, ytterbium and lutetium. Of these lanthanoid atoms, neodymium, europium and gadolinium are preferable.

Examples of a ligand of the complex include ligands described in G. Wilkinson, et al., Comprehensive Coordination Chemistry, published by Pergamon Press, 1987; H. Yersin, Photochemistry and Photophysics of Coordination Compounds, published by Springer-Verlag, 1987; and YAMAMOTO, Akio, Organometallic Chemistry - Principles and Applications, published by Shokabo Publishing Co., Ltd., 1982.

Also, examples of the host material which is contained in the light-emitting layer in the invention include materials as enumerated in the following paragraphs of hole injection layer, hole transport layer, electron injection layer and electron transport layer as well as a material having a carbazole skeleton, a material having a diarylamine skeleton, a material having a pyridine skeleton, a material having a pyrazine skeleton, a material having a triazine skeleton and a material having an arylsilane skeleton.

### ((Hole injection layer and hole transport layer))

The hole injection layer and the hole transport layer are each a layer having a function to receive a hole from the anode or the anode side to transport it into the cathode side. Specifically, the hole injection layer and the hole transport layer are each preferably a layer containing a carbazole derivative, a triazole derivative, an oxazole derivative, an oxadiazole derivative, an imidazole derivative, a polyarylalkane derivative, a pyrazoline derivative, a pyrazolone derivative, a phenylenediamine derivative, an arylamine derivative, an amino-substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidene based compound, a porphyrin based compound, an organosilane derivative, carbon or the like.

### ((Electron injection layer and electron transport layer))

The electron injection layer and the electron transport layer are each a layer having a function to receive an electron from the cathode or the cathode side to transport it into the anode side. Specifically, the electron injection layer and the electron transport layer are each preferably a layer containing a triazole derivative, an oxazole derivative, an oxadiazole derivative, an imidazole derivative, a fluorenone derivative, an anthraquinodimethane derivative, an anthrone derivative, a diphenylquinone derivative, a thiopyran dioxide derivative, a carbodiimide derivative, a fluorenylidenemethane derivative, a distyrylpyrazine derivative, aromatic ring tetracarboxylic acid anhydrides of naphthalene, perylene, etc., a phthalocyanine derivative, a metal complex of every kind represented by metal complexes of 8-quinolinol derivatives and metal complexes composed of, as a ligand, metal phthalocyanine, benzoxazole or benzothiazole, an organosilane derivative or the like.

### ((Hole blocking layer))

The hole blocking layer is a layer having a function to prevent a phenomenon in which the hole which has been transported into the light-emitting layer from the anode side passes through into the cathode side from occurring. In the invention, the hole blocking layer can be provided as an organic compound layer which is positioned adjacent to the light-emitting layer on the cathode side.

Examples of an organic compound constituting the hole blocking layer include aluminum complexes such as BAlq, triazole derivatives and phenanthroline derivatives such as BCP. Also, a layer having a function to prevent a phenomenon in which the electron which has been transported into the light-emitting layer from the cathode side passes through into the anode side from occurring may be provided on the position adjacent to the light-emitting layer on the anode side. The hole injection layer and hole transport layer may serve this function.

### <TFT display device>

The display substrate of the invention can be used as a substrate for image display device of a thin film transistor to produce a TFT. The method described in JP-T 10-512104 and others can be used as a method for producing TFT array. The substrate may also have a color filter for color display. The color filter can be produced by any methods. Photography can be used preferably.

### <Solar Cell>

The gas barrier layer of the invention can be used also as a sealing film for solar cell devices. Preferably, the gas barrier layer of the invention is used for sealing a solar cell device in such a manner that its adhesive layer is on the side near to the solar cell device. The solar cell devices for which the gas barrier layer of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

### «Examples»

The invention is described more concretely with reference to the following Examples. In the following Examples, the material used, its amount and the ratio, the details of the treatment and the treatment process may be suitably modified or changed. Accordingly, the invention should not be limited to these Examples.

### (Example 1)

### Preparation of Gas-Barrier Film:

Gas-barrier films having an inorganic layer and an organic layer provided on a substrate film (samples Nos. 101 to 103) were produced according to the process mentioned below. The details of the constitution of each gas-barrier film are shown in Table 1. The substrate film is a polyethylene naphthalate film (PEN, Teij in-Dupont' s Q65A having a thickness of 100 µm).

### [1] Formation of Inorganic Layer (X):

Using a reactive sputtering apparatus, an inorganic layer of aluminium oxide was formed. The concrete film formation condition is shown below.

The pressure in the vacuum chamber of the reactive sputtering apparatus was reduced to an ultimate vacuum degree of 5 x 10⁻⁴ Pa, using an oil rotatory pump and a turbomolecular pump. Next, argon was introduced into it as a plasma gas; and a power of 2000 W was applied to it from a plasma source. A high-purity oxygen gas was introduced into the chamber, and the film formation pressure was controlled at 0.3 Pa for a predetermined period of time to form an inorganic layer of aluminium oxide. Thus formed, the aluminium oxide film had a thickness of 40 nm and a film density of 3.01 g/cm³.

### [2] Formation of Organic Layer (Y, Z):

The organic layer was formed according to two methods of a solution-coating film formation method under normal pressure (organic layer Y) and a flash vapor deposition method under reduced pressure (organic layer Z). The details of film formation are shown below.

### Formation of organic layer (Y):

9 g of a photopolymerizing acrylate, tripropylene glycol diacrylate (TPGDA, by Daicel Sytec) and 0.1 g of a photopolymerization initiator (Ciba Specialty Chemicals' Irgacure 907) were dissolved in 190 g of methyl ethyl ketone to prepare a coating solution. The coating solution was applied onto a substrate film, using a wire bar, and then irradiated with UV rays at an illuminance of 350 mW/cm² and at a radiation dose of 500 mJ/cm², using an air-cooling metal halide lamp of 160 W/cm (by Eyegraphics) with nitrogen purging to an oxygen concentration of at most 0.1%, thereby forming an organic layer (Y). The film thickness was about 500 nm.

### Formation of organic layer (Z):

9.7 g of a photopolymerizing acrylate, butylethylpropanediol diacrylate (BEPGA, by Kyoei Chemical) and 0.3 g of a photopolymerization initiator (Lambertispa's EZACURE-TZT) were mixed to prepare a vapor deposition liquid. The vapor deposition liquid was applied onto a substrate for vapor deposition thereon, according to a flash vapor deposition method under a condition of inner pressure of 3 Pa in the vacuum chamber. Next, under the same vacuum degree condition, this was irradiated with UV rays at a radiation dose of 2 J/cm², thereby forming an organic layer (Z). The film thickness was about 1200 nm. For forming the organic layer (Z), used was an organic/inorganic laminate film formation device, Guardian 200 (by Vitex Systems).

### [3] Production of Gas-Barrier Film:

Gas-barrier films were produced by forming the above-mentioned inorganic layer and organic layer in order on a substrate film according to the constitution of the samples shown in Table 1. The films were produced according to the following two methods.

### [3-1] Method of repeating organic layer formation by solution coating and inorganic layer formation under reduced pressure

### (lamination A) :

An organic layer and an inorganic layer were alternately laminated on a substrate. An inorganic layer was laminated on an organic layer as follows: An organic layer was first formed by solution coating, and then this was put into a vacuum chamber, in which the pressure was reduced to a vacuum degree of at most 10⁻³ Pa. This was kept in the chamber for a predetermined period of time, and then an inorganic layer was formed on it. An organic layer was laminated on the inorganic layer as follows: Immediately after the formation of the inorganic layer, an organic layer was formed thereon according to a solution coating method.

### [3-2] Method of continuous formation of organic layer and inorganic layer under reduced pressure (lamination B):

Using the above-mentioned organic/inorganic laminate film formation apparatus, Guardian 200, an organic layer and an inorganic layer were laminated. In this apparatus, both the organic layer and the inorganic layer are formed in a reduced pressure environment, and the film formation chambers for organic layer and inorganic layer are connected to each other. In this, therefore, the two layers could be continuously formed in a reduced pressure environment. Accordingly, the film is not exposed to air until the completion of barrier film formation.

**Table 1**

| Sample No. | Layer Constitution | Lamination Method |
|---|---|---|
| 101 | PEN/Y/X/Y/X/Y/X/YX/Y | Lamination A |
| 102 | PEN/Z/X/Z/X/Z/X/ZX/Z | Lamination B |
| 103 | PEN/Y/X/Z/X/Z/X/ZX/Z | Lamination B |

### [4] Production of Organic EL Device:

The gas-barrier film prepared in the above was introduced into a vacuum chamber; and using an ITO target, a transparent electrode of an ITO thin film having a thickness of 0.2 µm was formed on the film according to a DC magnetron sputtering method. The substrate was etched in an aqueous oxalic acid solution (pKa = 1.04), and the ITO film-having gas-barrier film was put into a washing container, and ultrasonically washed with 2-propanol therein, and then processed for UV ozone treatment for 30 minutes. On the substrate (anode), the following organic compound layers were formed in order by vapor deposition according to a vacuum vapor deposition method.
(First Hole Transportation Layer)
   Copper phthalocyanine: film thickness 10 nm.
(Second Hole Transportation Layer)
   N,N'-diphenyl-N,N'-dinaphthylbenzidine: film thickness 40 nm.
(Light-Emitting Layer also serving as electron transportation layer)
   Tris(8-hydroxyquinolinato)aluminium: film thickness 60 nm.

Finally, 1 nm of lithium fluoride and 100 nm of metal aluminium were formed in order by vapor deposition, thereby forming a cathode; and a silicon nitride film having a thickness of 3 µm was formed on it according to a parallel plate CVD method, thereby constructing an organic EL device.

### [5] Pretreatment of Gas-Barrier Film for Sealing:

The gas-barrier film (not having an electrode) prepared in the above was pre-treated according to the following process. [5-1] Washing Step:

The gas-barrier film and a middle adhesion-power sheet (Sumiron's EC-315, having an adhesion power of 1.3 N/20 mm to glass plate) or a weak adhesion-power sheet (Sumiron's EC-310, having an adhesion power of 0.8 N/20 mm to glass plate) were stuck together, and then peeled from each other. Next, the gas-barrier film was put into a vacuum chamber, then oxygen gas was introduced thereinto to have a controlled vacuum degree of about 6 Pa, and the film was processed with an RF plasma apparatus having an RF power of 20 W (RFX-500, by Advanced Energy) for 2 minutes.

### [5-2] Drying Step:

The washed gas-barrier film was dried at 80°C for 1 hour, and then kept under a condition of 10⁻² Pa for 10 hours.

### [6] Application of Gas-Barrier Film on organic EL device:

Using a thermosetting adhesive (Epotec 310, by Daizo-Nichimori) , the gas-barrier film washed and dried in the manner as above, and the organic EL device substrate were stuck together in such a manner that the gas-barrier layer of the film could be on the side of the organic EL device, and heated at 65°C for 3 hours to cure the adhesive. 20 test pieces of every sample of the thus-sealed organic EL device (samples Nos. 201 to 203) were prepared. In the device, both the substrate and the sealing film comprises a resin as the main ingredient thereof, and therefore, the device was flexible.

### [7] Evaluation of Light-Emitting Surface of organic EL device:

Just after produced, the organic EL device (samples Nos. 201 to 203) was tested for light emission under application of 7 V thereto, using a source measure unit (SMU2400 Model by Keithley). Using a microscope, the light-emitting surface was observed, which confirmed uniform light emission by every device with no dark spot.

Next, the devices were stored in a dark room at 60°C and 90 % RH for 24 hours, and then tested for light emission. The proportion of the test pieces that gave dark spots larger than 300 µm in diameter is defined as a failure rate. Table 2 shows the failure rate of every tested device.

### (Comparative Example 1)

Organic EL devices (samples Nos. 301 to 303) were produced in the same manner as in Example 1, for which, however, an aqueous hydrochloric acid solution (pKa = -6) was used as the etchant in place of aqueous oxalic acid solution, and these were evaluated in the same manner as in Example 1. AS a result, many dark spots appeared in the entire light-emitting surface of every device. The failure rate of the tested device is shown in Table 2.

**Table 2**

| Sample | Failure Rate |
|---|---|
| 201 | 3.5 % |
| 202 | 2.3 % |
| 203 | 1.2 % |
| 301 | 32 % |
| 302 | 26 % |
| 303 | 18 % |

The above results confirm that the organic EL devices comprising a substrate produced according to the patterning method of the invention all have good quality.

## Claims

1. A method for patterning a display device substrate that has a gas-barrier layer comprising at least one organic region and at least one inorganic region, which comprises patterning the display device substrate by wet-etching with a weak acid or weak base etchant.

2. The patterning method according to claim 1, wherein the weak acid or the weak base of the etchant has a pKa falling within a range of from 0.5 to 10.

3. The patterning method according to claim 1 or 2, wherein the etchant is selected from an oxalic acid solution, an acetic acid solution, a carbonic acid solution and a phosphoric acid solution and a mixture of at least two of them.

4. The patterning method according to any one of claims 1 to 3, wherein the etchant is an aqueous solution of oxalic acid.

5. The patterning method according to any one of claims 1 to 4, wherein the display device substrate has a transparent electrode and the transparent electrode is subject to the patterning.

6. The patterning method according to any one of claims 1 to 5, wherein the display device substrate has a thin film layer of anode and the thin film layer is subject to the patterning.

7. The patterning method according to any one of claims 1 to 6, wherein the display device substrate has an ITO thin film and the ITO thin film is subject to the patterning.

8. The patterning method according to any one of claims 1 to 7, wherein the gas-barrier layer is a laminate comprising at least one organic layer and at least one inorganic layer.

9. The patterning method according to claim 8, wherein the at least one organic layer and the at least one inorganic layer are laminated alternately.

10. A display device substrate patterned by the patterning method of any one of claims 1 to 9.

11. A method for producing a display device, which comprises patterning a substrate by the patterning method of any one of claims 1 to 9.

12. A display device produced by the patterning method of claim 11.
